# EUROPÄISCHE PATENTSCHRIFT

(11) **EP 1 598 866 B1**
(45) Veröffentlichungstag und Bekanntmachung des Hinweises auf die Patenterteilung: **20.08.2008**
(21) Anmeldenummer: 04011767.3
(22) Anmeldetag: 18.05.2004
(51) Int. Cl.: H01L 23/427, H05K 7/20, F28D 15/04

(54) **Kühlvorrichtung**
Cooling device
Dispositif de refroidissement

(43) Veröffentlichungstag der Anmeldung: 23.11.2005
(73) Patentinhaber: Soemtron AG, 99610 Sömmerda (DE)
(72) Erfinder: Wellhöfer, Stefan, 99195 Schlossvippach (DE)
(74) Vertreter: Wächter, Jochen

(56) Entgegenhaltungen:
- EP-A- 0 348 838
- US-A- 5 216 580

## Beschreibung

Die Erfindung betrifft eine Kühlvorrichtung für vorzugsweise großflächige zu kühlende Einheiten, die hohe Wärmeleistungen abgeben.

Durch den stark zunehmenden Einsatz von elektrischen oder elektronischen Geräten sowohl in der Industrie als auch in vielen Bereichen des täglichen Lebens existiert für Kühlvorrichtungen ein großer Bedarf. Dies gilt in erheblichem Maß auch für den Outdoorbereich, wo bislang aktive Kühlgeräte wie z.B. Lüfter eingesetzt werden. Diese bedingen in Betrieb eine unerwünschte Geräuschbildung und führen beim Ausfall unter Umständen schnell zu einer Überhitzung der zu kühlenden Einheit und deren Zerstörung.

Insbesondere bei großflächigen zu kühlenden Einheiten ist das Anbringen und der Betrieb von aktiven Kühlgeräten, die die geforderte hohe Kühlleistung erbringen, mit hohem Aufwand verbunden.

Allgemein bekannt ist die Verwendung von Heat-Pipes als Kühlvorrichtungen, bei denen durch die Verdampfung von Flüssigkeit und deren Kondensation ein Kühlprofilkörper Wärme abtransportiert wie z.B. in der US 5 216 580 oder in der EP 0 348 838. Herkömmliche Heat-Pipes sind jedoch für den großflächigen Einsatz nicht geeignet, da die Wege von der Verdampferfläche zur Kondensationsfläche relativ groß sind. Der Einsatz von mehreren Heat-Pipes auf einer großflächigen zu kühlenden Einheit ist kostspielig und aufgrund einer begrenzten abführbaren Wärmemenge ungeeignet.

Es ist daher die Aufgabe der vorliegenden Erfindung, eine Kühlvorrichtung für großflächige zu kühlende Einheiten zu liefern, die einen hohen Wirkungsgrad aufweist, vielseitig einsetzbar ist und deren Herstellung und Verwendung sehr einfach und kostengünstig ist.

Diese Aufgabe wird durch die Merkmale des Anspruchs 1 gelöst.

Erfindungsgemäß wird eine Kühlvorrichtung vorgeschlagen, die eine Vielzahl von nebeneinander angeordneten, einseitig offenen Verdampfungskammern mit Begrenzungswänden aus wärmeleitendem Material aufweist, an deren Innenflächen jeweils ein Vlies angeordnet ist, das mit einer Flüssigkeit getränkt ist, und die geeignet sind, über ihre Außenflächen mit einem zu kühlenden Material in Kontakt gebracht zu werden, und eine der Anzahl von Verdampfungskammern entsprechenden Vielzahl von nebeneinander angeordneten, einseitig offenen Kondensationskammern mit Begrenzungswänden aus wärmeleitendem Material, die geeignet sind, über ihre Außenflächen Wärme an die Umgebung abzugeben, wobei jeweils eine Verdampfungskammer und eine Kondensationskammer über ihre offenen Seiten derart verbunden sind, dass zwischen Verdampfungskammer und Kondensationskammer ein gasdicht abgeschlossener, teilevakuierter Raumbereich ausgebildet ist, so dass im Betrieb die im Vlies einer Verdampfungskammer enthaltene Flüssigkeit im Raumbereich verdampft, an der Innenfläche der zugeordneten Kondensationskammer kondensiert und wieder dem Vlies zugeführt wird, wobei die Begrenzungswände der Verdampfungskammern und die Begrenzungswände der Kondensationskammern durch geeignete Kunststoffelemente thermisch und elektrisch voneinander entkoppelt sind.

Eine derartige erfindungsgemäße Kühlvorrichtung ermöglicht es nunmehr, selbst große Wärmemengen in kürzester Zeit aufgrund des geringen Weges von der Verdampferfläche zur Kondensationsfläche abzutransportieren. Dabei lassen sich die Verdampferflächen und die Kondensationsflächen beliebig groß gestalten und für den entsprechenden Einsatz optimieren. Durch die elektrische und wärmetechnische Entkopplung von Verdampfungs- und Kondensationsflächen ist der Wärmedurchgangswiderstand der erfindungsgemäßen Kühlvorrichtung sehr gering. Ein Einsatz im Freien ist ebenso möglich wie auch eine Kühlung hochspannungsführender Bauteile.

Vorteilhafterweise ist an den Innenflächen der Kondensationskammern jeweils eine Metallgaze angeordnet. Dadurch wird die kondensierte Flüssigkeit aufgefangen und damit der Wirkungsgrad der Kühlvorrichtung gesteigert. Aufgrund der Kapillarwirkung ist somit außerdem ein Einsatz der Kühlvorrichtung in jeder Orientierung möglich.

Bevorzugterweise sind die Begrenzungswände und Verbindungsstege der Verdampfungskammern und Kondensationskammern jeweils aus einem Stück als stranggepresstes Profil gebildet. Es ist insbesondere ein Vorteil der vorliegenden Erfindung, dass das Profil derart ausgebildet ist, dass die Verdampfungs- und Kondensationskammern im Querschnitt jeweils U-förmig mit dazwischen liegenden Verbindungsstegen nebeneinander angeordnet sind. Damit lassen sich Kühlsysteme der erfindungsgemäßen Art sehr einfach und kostengünstig herstellen und bieten vielfältige Gestaltungs- und Anpassungsmöglichkeiten.

Vorteilhafterweise sind die aus Verdampfungs- und Kondensationskammern gebildeten Raumbereiche an ihren Seiten jeweils mit Abdeckelementen gasdicht abgeschlossen. Insbesondere ist es von Vorteil, dass die Abdeckelemente aus Polyurethan gebildet sind. Derartige Abdeckelemente aus Kunststoff sind einfach und günstig herzustellen und bieten für die Aufrechterhaltung des Vakuums sehr gute Eigenschaften, da sie sich bei Vakuum zusammenziehen und somit zusätzlich abdichten.

Die erfindungsgemäße Kühlvorrichtung weist bevorzugterweise Kunststoffelemente als zwischen den Profilen angeordnete Dichtleisten auf, die die thermische und elektrische Entkopplung der Verdampfungs- und Kondensationskammern gewährleisten.

Um die Wärmeabgabeleistung zu erhöhen, befindet sich in den Raumbereichen als Flüssigkeit vorteilhafterweise Alkohol oder destilliertes Wasser.

Vorzugsweise sind die Außenflächen der Kondensationskammern oberflächenvergrößert. Dies erhöht die Wärmeabgabeleistung des Kühlsystems erheblich.

Bevorzugterweise ist jede Kondensationskammer oberhalb der zugehörigen Verdampfungskammer angeordnet, wodurch die kondensierte Flüssigkeit schnell dem Vlies zugeführt wird und eine kontinuierlich hohe Wärmeabgabeleistung sichergestellt ist.

Weitere Einzelheiten, Vorteile und Merkmale der vorliegenden Erfindung ergeben sich aus der nachfolgenden Beschreibung unter Bezugnahme auf die beigefügten Zeichnungen.

Diese zeigen:
- Fig. 1: eine Querschnittansicht einer ersten Ausführungsform der erfindungsgemäßen Kühlvorrichtung;
- Fig. 2: eine Explosionsdarstellung der Kühlvorrichtung aus Figur 1;
- Fig. 3: eine Querschnittansicht einer zweiten Ausführungsform der erfindungsgemäßen Kühlvorrichtung; und
- Fig. 4: eine Explosionsdarstellung der Kühlvorrichtung aus Figur 3.

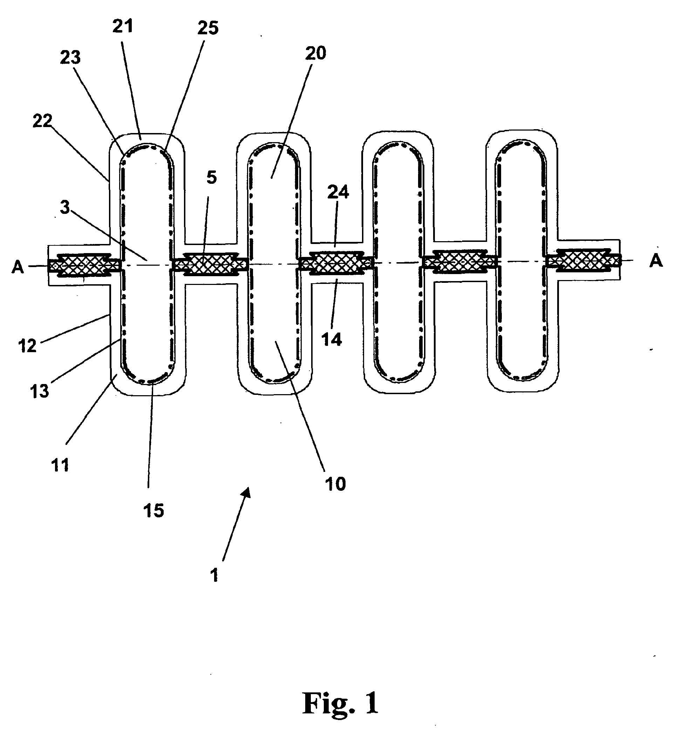

Figur 1 zeigt eine erste bevorzugte Ausführungsform der vorliegenden Erfindung, wobei die Kühlvorrichtung 1 im Querschnitt dargestellt ist und eine Symmetrie bezüglich der durch A-A definierten Ebene aufweist. In der unteren Hälfte weist die Kühlvorrichtung 1 vier Verdampfungskammern 10 auf, die durch Begrenzungswände 11 begrenzt sind, die jeweils mit Verbindungsstegen 14 miteinander verbunden sind. Die Außenflächen 12 der Verdampfungskammern 10 stehen mit der zu kühlenden Einheit (nicht gezeigt) thermisch in Verbindung. Auf den Innenflächen 13 der Verdampfungskammern 10 ist ein Vlies 15 angeordnet, das mit Flüssigkeit, wie beispielsweise destilliertem Wasser oder Alkohol, getränkt ist.

In der oberen Hälfte weist die Kühlvorrichtung 1 vier Kondensationskammern 20 auf, die durch Begrenzungswände 21 begrenzt sind, die jeweils wiederum mit Verbindungsstegen 24 miteinander verbunden sind. Die Außenflächen 22 der Kondensationskammern 20 sind geeignet, Wärme an ihre Umgebung abzugeben. An den Innenflächen 23 der Kondensationskammern 20 ist eine vorzugsweise aus Metall gebildete Gaze 25 angeordnet, die dazu dient, die kondensierte Flüssigkeit aufzunehmen und zum Vlies 15 der Verdampfungskammer 10 zurückzuführen. Die Verwendung der Gaze 25 ist aufgrund der Kapillarwirkung zweckmäßig, weil die Kühlvorrichtung dann auch z.B. "auf den Kopf gestellt" arbeiten kann, jedoch nicht für die Funktion der erfindungsgemäßen Kühlvorrichtung notwendig. Die Gaze 25 verhindert u.a. auch, dass Tropfen der kondensierten Flüssigkeit direkt in die Verdampfungskammern 10 zurückfallen. Die einseitigen Öffnungen der Verdampfungskammern 10 und der Kondensationskammern 20 liegen einander in der Ebene A-A im wesentlichen gegenüber, wodurch sich durch jeweils eine Verdampfungskammer 10 und Kondensationskammer 20 ein Raumbereich 3 ergibt, der evakuiert wird. Die Begrenzungswände 11, 21 und Verbindungsstege 14, 24 der nebeneinander liegenden Verdampfungskammern 10 bzw. Kondensationskammern 20 sind durch ein im Querschnitt vorzugsweise U-förmiges oder patronenförmiges Profil gebildet, das in der bevorzugten Ausführungsform aus stranggepresstem Aluminium hergestellt ist.

Das Verdampfungsprofil der unteren Hälfte ist vom Kondensationsprofil der oberen Hälfte in einem vorbestimmten Abstand entfernt angeordnet, wobei dieser Abstand durch die Dicke von Kunststoffelementen 5, die sich zwischen den Verbindungsstegen 14, 24 befinden, bestimmt ist. Durch die Kunststoffelemente 5 sind die Verdampfungskammern 10 und Kondensationskammern 20 voneinander thermisch und elektrisch entkoppelt. Als Material der Kunststoffelemente 5 können Kunststoffe mit geeigneten thermischen und elektrischen Eigenschaften eingesetzt werden. Selbstverständlich sind für die Verdampfungs- und Kondensationsprofile auch andere Metalle als Aluminium oder andere wärmeleitende Materialien möglich.

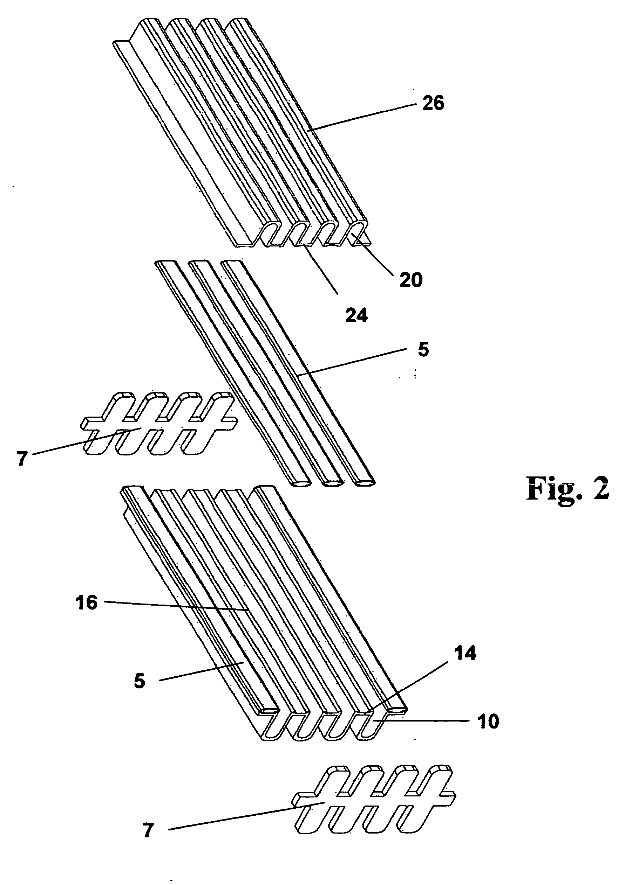

In Figur 2 sind die Hauptbestandteile der erfindungsgemäßen Kühlvorrichtung aus Figur 1 unter Verwendung der selben Bezugszeichen in einer Explosionsdarstellung abgebildet. Die Profile 16, 26 sind übereinander angeordnet, wobei sich zwischen den Verbindungsstegen 14, 24 die Kunststoffelemente 5 befinden. Die Verbindungsstege 14, 24 können beispielsweise derart geformt sein, dass die Kunststoffelemente 5 schienenartig einschiebbar sind, wodurch sich ein zugfester und gasdichter Verbund der beiden Profile 16, 26 ergibt. Die auf diese Weise fest miteinander verbundenen Profile 16, 26 sind seitlich mit den Abdeckelementen 7 abgeschlossen. Diese Abdeckelemente 7 sind vorzugsweise aus Polyurethankunststoff ausgeführt, der sich bei (Teil-) Evakuierung der Raumbereiche mittels als solchen bekannten Vakuumpumpen in Richtung auf eine noch bessere Abdichtung verformt.

Bei der in Figur 1 und Figur 2 dargestellten bevorzugten Ausführungsform der erfindungsgemäßen Kühlvorrichtung 1 sind die Verdampfungs- und Kondensationsklammern 10, 20 senkrecht angeordnet. Eine Verwendung dieser Ausführungsform der Kühlvorrichtung 1 bei nicht senkrechter Anordnung ist selbstverständlich ebenso möglich, obwohl dadurch der Wirkungsgrad der Kühlvorrichtung geringfügig erniedrigt wird.

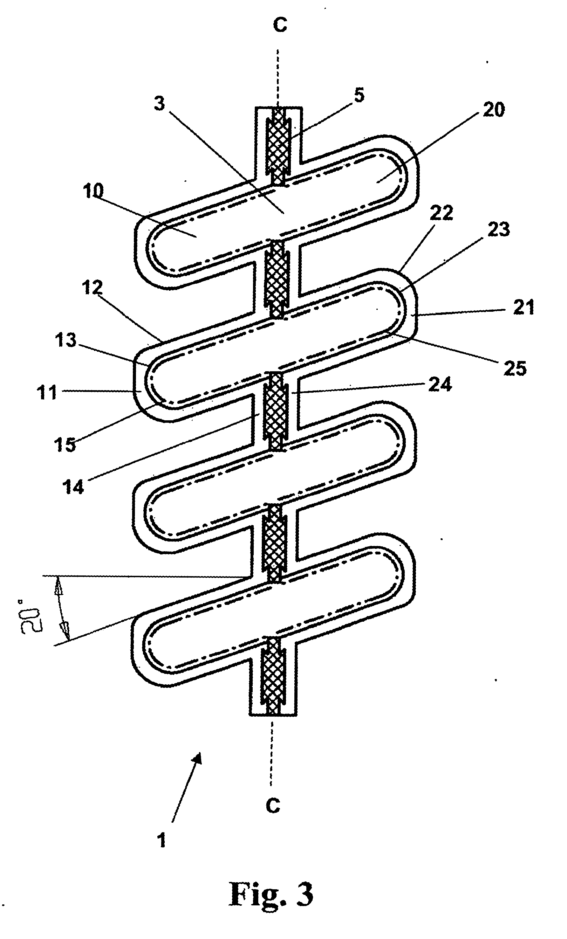

Figur 3 zeigt eine zweite bevorzugte Ausführungsform der erfindungsgemäßen Kühlvorrichtung 1, bei der die Verdampfungskammern 10 und Kondensationskammern 20 nicht spiegelsymmetrisch bezüglich der durch C-C definierten Symmetrieebene angeordnet sind. Im hier gezeigten Beispiel sind die Verdampfungskammern 10 bzw. Kondensationskammern 20 um 20° bezüglich der senkrecht auf der Verbindung C-C stehenden Ebene schräg nach unten bzw. schräg nach oben parallel nebeneinander angeordnet. Selbstverständlich können bei dieser Ausführungsform auch andere Winkel der Schrägstellung gewählt werden. Ein besonderer Vorteil dieser Ausführungsform ist, dass sich beim Kippen der gesamten Kühlvorrichtung 1 in der durch C-C definierten Ebene kaminartige Luftschächte zwischen den Kondensationskammern 20 bilden lassen, die die Kühlleistung der Vorrichtung erhöhen.

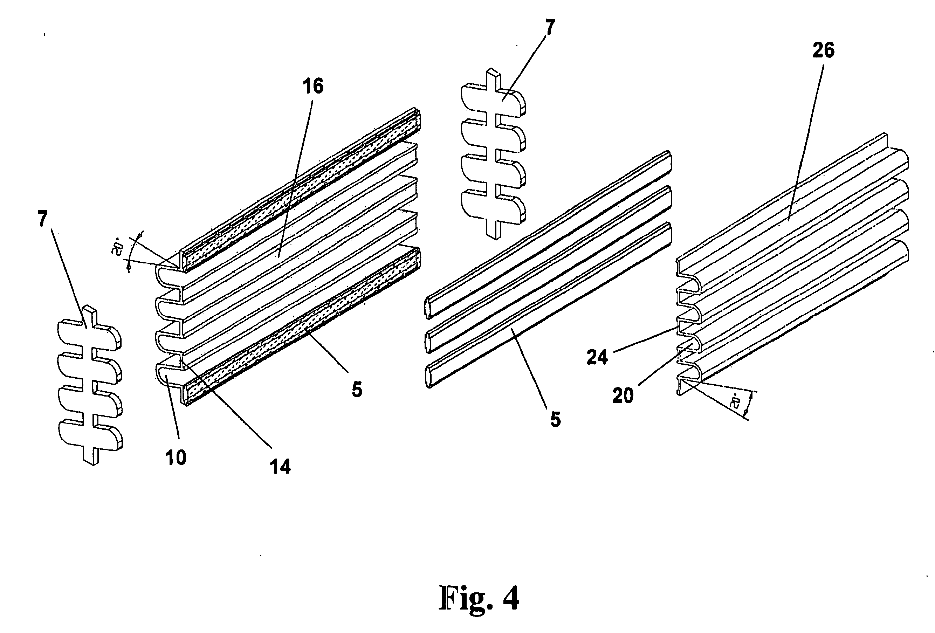

Figur 4 zeigt in Explosionsdarstellung die Hauptbestandteile der erfindungsgemäßen Kühlvorrichtung aus Figur 3. Es finden dabei die selben Bezugszeichen wie in Figur 2 Verwendung.

Im folgenden wird der Kühlprozess gemäß der vorliegenden Erfindung erläutert. Zunächst erwärmen sich die Begrenzungswände 11 der Verdampfungskammern 10, da die Außenflächen 12 mit dem zu kühlenden Medium, z.B. heißem Gas oder der zu kühlenden Einheit, z.B. einem elektronischen Bauteil, in Kontakt stehen. Die Begrenzungswände 11 der Verdampfungskammern 10 bestehen aus sehr gut wärmeleitendem Material und die im Vlies 15 enthaltene Flüssigkeit verdampft im teilevakuierten Raumbereich 3 bereits bei relativ niedrigen Temperaturen, da aufgrund des Vakuums die Siedetemperatur sinkt. Der Flüssigkeitsdampf wandert aufgrund des Temperaturunterschieds in Richtung der Kondensationskammern 20, diffundiert durch die Gaze 25 hindurch und kondensiert an der Innenwand 23 der Kondensationskammern 20. Dadurch wird Wärme an die Begrenzungswände 21 der Kondensationskammern 20 abgegeben, die über die Außenwand 22 der Kondensationskammer 20 auf die Umgebung übertragen wird. Die abgekühlte, kondensierte Flüssigkeit läuft an der Innenwand 23 bzw. der Metallgaze 25 wieder in Richtung der Verdampfungskammern 10 und wird wieder dem Vlies 15 zugeführt.

Dieser Wärmeübertragungsmechanismus über verdampfte Flüssigkeit ist äußerst wirksam, vor allem deshalb, da die Wege von der Verdampferfläche zur Kondensationsfläche sehr klein sind. Er bietet überdies den Vorteil, dass in der Kühlvorrichtung relativ niedrige Temperaturen herrschen. Auf diese Weise können erhebliche Wärmemengen in kürzester Zeit transportiert werden. Darüber hinaus läßt sich die erfindungsgemäße Kühlvorrichtung derart gestalten, dass die Verdampfer- und Kondensationsflächen beliebig groß sind. Im Vergleich zu herkömmlichen Kühlvorrichtungen, die nach dem Heat-Pipe-Prinzip funktionieren, weist der Gegenstand der vorliegenden Erfindung einen wesentlich höheren Wirkungsgrad auf. Dieser hohe Wirkungsgrad sowie die elektrische und thermische Entkopplung von Verdampfer- und Kondensationsflächen führt dazu, dass der Wärmedurchgangswiderstand des Kühlsystems sehr gering ist.

Durch die vorgeschlagene Verwendung von Strangpressprofilen und Kunststofformteilen ist die Herstellung von erfindungsgemäßen Kühlvorrichtungen sehr einfach und kostengünstig.

Somit wird eine Kühlvorrichtung geschaffen, die auch großflächige zu kühlende Einheiten effektiv kühlt, in unterschiedlichsten Umgebungen wie beispielsweise im Freien einsetzbar ist, die einen hohen Wirkungsgrad aufweist, d.h. hohe Wärmeleistungen abführen kann, und sowohl einfach als auch relativ kostengünstig herstellbar ist. Natürlich ist dieses Prinzip einer passiven Kühlvorrichtung für große Flächen nicht auf die exakte Ausführungsform beschränkt, wie sie in der bisherigen Beschreibung offenbart ist.

Schließlich ist es für die Anordnung der Verdampfungs- und Kondensationskammern 10, 20 auch denkbar, dass diese nicht parallel nebeneinander, sondern beispielsweise konzentrisch, d.h. ringförmig, oder auch unregelmäßig nebeneinander angeordnet sind.

Insgesamt kann die erfindungsgemäße Kühlvorrichtung flexibel an eine Vielzahl von äußeren Rahmenbedingungen angepasst werden. Es wird somit eine Lösung geschaffen, die äußerst wirkungsvoll Wärme abführen kann und umweltfreundlich sowie wartungsfrei funktioniert.

## Patentansprüche

1. Kühlvorrichtung mit einer Vielzahl von nebeneinander angeordneten, einseitig offenen Verdampfungskammern (10) mit Begrenzungswänden (11) aus wärmeleitendem Material, an deren Innenflächen (13) jeweils ein Vlies (15) angeordnet ist, das mit einer Flüssigkeit getränkt ist, und die geeignet sind, über ihre Außenflächen (12) mit einem zu kühlenden Material in Kontakt gebracht zu werden, und einer der Anzahl von Verdampfungskammern (10) entsprechenden Vielzahl von nebeneinander angeordneten, einseitig offenen Kondensationskammern (20) mit Begrenzungswänden (21) aus wärmeleitendem Material, die geeignet sind, über ihre Außenflächen (22) Wärme an die Umgebung abzugeben, wobei jeweils eine Verdampfungskammer (10) und eine Kondensationskammer (20) über ihre offenen Seiten derart verbunden sind, dass zwischen Verdampfungskammer (10) und Kondensationskammer (20) ein gasdicht abgeschlossener, teilevakuierter Raumbereich (3) ausgebildet ist, so dass im Betrieb die im Vlies (15) einer Verdampfungskammer (10) enthaltene Flüssigkeit im Raumbereich (3) verdampft, an der Innenfläche (23) der zugeordneten Kondensationskammer (20) kondensiert und wieder dem Vlies (15) zugeführt wird, wobei die Begrenzungswände (11) der Verdampfungskammern (10) und die Begrenzungswände (21) der Kondensationskammern (20) durch geeignete Kunststoffelemente (5) thermisch und elektrisch voneinander entkoppelt sind.

2. Kühlvorrichtung nach Anspruch 1, **dadurch gekennzeichnet, dass** an den Innenflächen (23) der Kondensationskammern (20) jeweils eine Gaze (25) angeordnet ist.

3. Kühlvorrichtung nach Anspruch 1 oder 2, **dadurch gekennzeichnet, dass** die Begrenzungswände (11, 21) der Verdampfungs- (10) und Kondensationskammern (20) jeweils aus einem stranggepressten Profil (16, 26) gebildet sind.

4. Kühlvorrichtung nach Anspruch 3, **dadurch gekennzeichnet, dass** das Profil (16, 26) derart ausgebildet ist, dass die Verdampfungs- (10) und Kondensationskammern (20) im Querschnitt jeweils U-förmig mit dazwischen liegenden Verbindungsstegen (14, 24) geformt sind.

5. Kühlvorrichtung nach einem der vorangehenden Ansprüche, **dadurch gekennzeichnet, dass** die Raumbereiche (3) an ihren Seiten jeweils mit Abdeckelementen (7) gasdicht abgeschlossen sind.

6. Kühlvorrichtung nach Anspruch 5, **dadurch gekennzeichnet, dass** die Abdeckelemente (7) aus Polyurethan gebildet sind.

7. Kühlvorrichtung nach einem der vorangehenden Ansprüche, **dadurch gekennzeichnet, dass** die Kunststoffelemente (5) als zwischen den Profilen (16, 26) angeordnete Dichtleisten ausgebildet sind.

8. Kühlvorrichtung nach einem der vorangehenden Ansprüche, **dadurch gekennzeichnet, dass** die Flüssigkeit Alkohol oder destilliertes Wasser ist.

9. Kühlvorrichtung nach einem der vorangehenden Ansprüche, **dadurch gekennzeichnet, dass** die Außenflächen (22) der Kondensationskammern (20) oberflächenvergrößert sind.

10. Kühlvorrichtung nach einem der vorangehenden Ansprüche, **dadurch gekennzeichnet, dass** jede Kondensationskammer (20) oberhalb der zugehörigen Verdampfungskammer (10) angeordnet ist.

## Claims

1. A cooling device comprising a plurality of evaporation chambers (10) positioned adjacent to each other, each of the evaporation chambers having one open side and boundary walls (11) of a thermally conductive material, wherein on the inner surfaces (13) of the boundary walls a fleece (15) soaked with a liquid is arranged, and the outer surfaces (12) of the boundary walls being suitable for being brought in contact with a material to be cooled, and, corresponding to the number of evaporation chambers (10), a plurality of condensation chambers (20) positioned adjacent to each other, each of the condensation chambers (20) having one open side and boundary walls (21) of a thermally conductive material, which are suitable for dissipating heat to the surrounding area through their outer surfaces (22), wherein each evaporation chamber (10) is in communication with a predetermined condensation chamber (20) via their open sides such that a partially evacuated spatial area (3) which is sealed in a gas-tight manner is formed between the evaporation chamber (10) and the condensation chamber (20) such that during operation the liquid contained in the fleece (15) of an evaporation chamber (10) evaporates in the spatial area (3), condenses on the inner surface (23) of the corresponding condensation chamber (20) and is passed again to the fleece (15), wherein the boundary walls (11) of the evaporation chambers (10) and the boundary walls (21) of the condensation chambers (20) are thermally and electrically decoupled from each other by suitable plastic elements (5).

2. The cooling device of claim 1, **characterised in that** at the inner surface (23) of the condensation chambers (20) a gauze (25) is arranged.

3. The cooling device of claim 1 or 2, **characterised in that** the boundary walls (11, 21) of the evaporation chambers (10) and the condensation chambers (20) each consist of an extruded profiled element (16, 26).

4. The cooling device of claim 3, **characterised in that** the profiled element (16, 26) is formed such that the evaporation chambers (10) and the condensation chambers (20) each have a U-shaped cross-section with connecting webs (14, 24) arranged between adjacent chambers.

5. The cooling device of any of the preceding claims, **characterised in that** the spatial areas (3) are sealed in a gas-tight manner at their sides by covering elements (7).

6. The cooling device of any of the preceding claims, **characterised in that** the covering elements (7) are made of polyurethane.

7. The cooling device of any of the preceding claims, **characterised in that** the plastic elements (5) are formed as sealing strips arranged between the profiled elements (16, 26).

8. The cooling device of any of the preceding claims, **characterised in that** the liquid is alcohol or distilled water.

9. The cooling device of any of the preceding claims, **characterised in that** the outer surfaces (22) of the condensation chambers (20) have an enlarged surface area.

10. The cooling device of any of the preceding claims, **characterised in that** each condensation chamber (20) is arranged above the corresponding evaporation chamber (10).

## Revendications

1. Dispositif de refroidissement comportant une pluralité de chambres d'évaporation (10) ouvertes d'un côté, juxtaposées les unes aux autres, avec parois de délimitation (11) en matériau thermoconducteur, sur les faces intérieures desquelles (13) est disposé chaque fois un non tissé (15) qui est imprégné d'un liquide, et qui sont adaptées, par leurs faces extérieures (12) pour être amenées en contact avec un matériau à refroidir, et une pluralité, correspondant au nombre des chambres d'évaporation, de chambres de condensation (20) ouvertes d'un côté, juxtaposées les unes aux autres, avec parois de délimitation (21) en matériau thermoconducteur, qui sont aptes, par leurs faces extérieures (22) à donner de la chaleur dans l'environnement, où chaque fois une chambre d'évaporation (10) et une chambre de condensation (20) sont reliées par leurs côtés ouverts, de telle façon qu'il se forme entre la chambre d'évaporation (10) et la chambre de condensation (20) une zone spatiale (3) partiellement en évacuation, fermée de manière étanche aux gaz, de sorte qu'en service, le liquide contenu dans le non tissé (15) d'une chambre d'évaporation (10) s'évapore dans la zone spatiale (3), se condense sur la face intérieure (23) de la chambre de condensation (20) associée et est renvoyé au non tissé (15), les parois de délimitation (11) des chambres d'évaporation (10) et les parois de délimitation (21) des chambres de condensation (20) étant isolées thermiquement et électriquement les unes des autres par des éléments en matière plastique (5) adaptés.

2. Dispositif de refroidissement selon la revendication 1, **caractérisé en ce qu'**une gaze (25) est chaque fois disposée sur les faces intérieures (23) des chambres de condensation (20).

3. Dispositif de refroidissement selon la revendication 1 ou 2, **caractérisé en ce que** les parois de délimitation (11, 21) des chambres d'évaporation (10) et de condensation (20) sont chaque fois constituées d'un profilé extrudé (16, 26).

4. Dispositif de refroidissement selon la revendication 3, **caractérisé en ce que** le profilé (16, 26) est réalisé de telle façon qu'en coupe transversale les chambres d'évaporation (10) et de condensation (20) sont chaque fois réalisées en forme de U avec des montants de liaisons (14, 24) intercalés.

5. Dispositif de refroidissement selon l'une des revendications précédentes, **caractérisé en ce que** sur leurs côtés, les zones spatiales (3) sont fermées de manière étanche aux gaz chaque fois avec des éléments de couverture (7).

6. Dispositif de refroidissement selon la revendication 5, **caractérisé en ce que** les éléments de couverture (7) sont réalisés en polyuréthanne.

7. Dispositif de refroidissement selon l'une des revendications précédentes, **caractérisé en ce que** les éléments en matière plastique (5) sont réalisés sous forme de baguettes d'étanchéité disposées entre les profilés (16, 26).

8. Dispositif de refroidissement selon l'une des revendications précédentes, **caractérisé en ce que** le liquide est de l'alcool ou de l'eau distillée.

9. Dispositif de refroidissement selon l'une des revendications précédentes, **caractérisé en ce que** les faces extérieures (22) des chambres de condensation (20) sont agrandies en surface.

10. Dispositif de refroidissement selon l'une des revendications précédentes, **caractérisé en ce que** chaque chambre de condensation (20) est disposée au-dessus de la chambre d'évaporation (10) associée.
